# FASCICULE DE BREVET EUROPEEN

(11) **EP 2 351 114 B1**
(45) Date de publication et mention de la délivrance du brevet: **15.08.2018**
(21) Numéro de dépôt: 09760209.8
(22) Date de dépôt: 23.10.2009
(51) Int. Cl.: H01L 41/00, H01F 10/13

(54) **PROCEDE ET DISPOSITIF D'ACTIONNEMENT MAGNETIQUE**
VERFAHREN UND VORRICHTUNG FÜR MAGNETISCHEN ANTRIEB
PROCESS AND DEVICE FOR MAGNETIC ACTUATING

(30) Priorité: 24.10.2008 FR 0857257
(43) Date de publication de la demande: 03.08.2011
(73) Titulaire: Institut Polytechnique de Grenoble, 38000 Grenoble (FR); Centre National de la Recherche Scientifique, 75794 Paris Cedex 16 (FR)
(72) Inventeur: O'BRIEN, Daniel, Sunnyvale, California 94086 (US); DELAMARE, Jérôme, F-38000 Grenoble (FR); CUGAT, Orphée, F-38320 Poisat (FR); GEOFFROY, Olivier, F-38400 Saint Martin D'heres (FR)
(74) Mandataire: Hautier IP
(86) Numéro de dépôt international: PCT/FR2009/052046
(87) Numéro de publication internationale: WO 2010/046614

(56) Documents cités:
- WO-A-98/44572
- TOSHIYUKI UENO ET AL: "Linear Step Motor Based on Magnetic Force Control Using Composite of Magnetostrictive and Piezoelectric Materials" IEEE TRANSACTIONS ON MAGNETICS, IEEE SERVICE CENTER, NEW YORK, NY, US, vol. 43, no. 1, 1 janvier 2007 (2007-01-01), pages 11-14, XP011152115 ISSN: 0018-9464

## Description

La présente invention concerne le domaine des actionneurs magnétiques, notamment pour les micro- et nanotechnologies.

L'invention concerne plus particulièrement un procédé et un dispositif d'actionnement magnétique ne nécessitant aucun courant électrique important ni bobinage électrique.

L'actionnement magnétique de systèmes est couramment utilisé et apprécié dans l'industrie et la recherche car les interactions magnétiques offrent de hautes densités d'énergie et d'excellents rendements de conversion entre énergies mécanique et électrique.

Un tel actionnement magnétique nécessite traditionnellement la mise en oeuvre de courants électriques plus ou moins élevés au sein de conducteurs et/ou de bobinages interagissant avec des aimants permanents et/ou des matériaux magnétiques doux ou même avec d'autres conducteurs. Or, la circulation de ces courants électriques dans des conducteurs engendre des échauffements et des pertes par effet Joule, qui réduisent le rendement des systèmes et, dans le cas de systèmes embarqués ou nomades, réduisent également l'autonomie des sources d'énergie électrique.

De plus, dans les systèmes de petite taille tels les micro- ou nanosystèmes, réchauffement résultant des pertes par effet Joule peut engendrer une altération des composants, voire leur destruction, ainsi que des parasites dans certains cas ou applications.

Enfin, la circulation de courants électriques peut également, notamment lorsque les courants sont forts, provoquer une désaimantation ou un changement d'aimantation de certains aimants permanents au sein des systèmes, perturbant leur fonctionnement.

La demande de brevet WO 98/44572 A1 et l'article de UENO et AL:"Linear step motor based on magnetic force control using composite of Magnetostrictive and Piezoelectric materials", IEEE Transactions on magnetics, IEEE service center, New-York, US, vol. 43, N°1, 1 janvier 2007, décrivent des procédés d'actionnement magnétiques mettant en oeuvre la possibilité de faire varier la valeur, que l'on peut qualifier de grandeur "scalaire", de la perméabilité magnétique d'un matériau magnétostrictif lorsqu'il est soumis à une contrainte mécanique afin d'obtenir un mouvement ou un actionnement. La contrainte appliquée peut être globale sur tout le matériau magnétostrictif, ce qui change la force d'interaction avec un aimant placé à proximité. La contrainte peut également être localisée sur une portion seulement du matériau, ce qui affecte localement la valeur de sa perméabilité, et peut avoir pour effet un déséquilibre des forces magnétiques en jeu apte à générer un mouvement, qui peut être une rotation. Cette rotation peut être entretenue par exemple en changeant progressivement l'endroit où est localisée la contrainte, avec plusieurs actionneurs piézoélectriques en étoile par exemple, ou appliqués sur plusieurs segments séparés d'un anneau de matériau magnétostrictif. Ces techniques sont donc contraignantes sur le plan de l'application des contraintes nécessaires à l'initiation et l'entretien du mouvement induit.

Un premier objectif de l'invention est de proposer un nouveau procédé d'actionnement magnétique que ne souffre pas des inconvénients précédemment évoqués des procédés d'actionnement magnétique connus.

Un autre objectif de l'invention est de proposer un procédé d'actionnement magnétique qui soit très simple et économique à mettre en oeuvre.

Un autre objectif de l'invention est de proposer un procédé d'actionnement magnétique qui puisse aisément être adapté à des micro- et nanosystèmes.

Ces différents objectifs sont atteints conformément à la présente invention par un procédé d'actionnement magnétique, selon lequel on dirige un mobile aimanté au moyen d'au moins un élément magnétique disposé en regard dudit mobile aimanté, et qui est caractérisé en ce que l'on fait tourner la direction privilégiée (ou axe facile) d'aimantation en tout point dudit élément par application d'au moins une contrainte mécanique sur le(s) dit(s) élément(s) magnétique(s), provoquant une anisotropie au sein dudit élément et entraînant ainsi le mobile aimanté suivant une direction linéaire ou angulaire privilégiée.

Le procédé de l'invention procure l'avantage déterminant de permettre l'actionnement d'un mobile aimanté sans force magnétique obtenue au moyen d'un courant électrique, ce qui permet ainsi de supprimer les problèmes majeurs liés à ces courants, notamment la consommation, les pertes thermiques par effet Joule et leurs inconvénients connexes.

De plus, le procédé de l'invention présente l'avantage de pouvoir être mis en oeuvre selon de multiples modalités d'application de la contrainte mécanique sur l'élément magnétique, ce qui procure une facilité d'adaptation du procédé d'actionnement en fonction des applications dédiées et des dimensionnement des systèmes dans lequel le procédé est exploité.

La présente invention se différencie par ailleurs fondamentalement de l'art antérieur par le fait qu'elle exploite, au contraire d'une variation de la valeur de perméabilité locale ou globale d'un matériau magnétostrictif, l'aspect intrinsèquement directionnel, que l'on peut qualifier de vectoriel, de la direction privilégiée aimantation, également appelée axe facile d'aimantation, de matériaux magnétostrictifs soumis à une contrainte unidirectionnelle, qui peut être angulairement orientée. En particulier, l'orientation de cette direction de facile aimantation peut être contrôlée par la direction et l'amplitude d'une contrainte mécanique unidirectionnelle à laquelle le matériau est soumis.

Selon l'invention, l'élément magnétique est avantageusement constitué d'un matériau magnétostrictif magnétiquement doux dont l'axe facile d'aimantation peut tourner sous l'effet d'une contrainte mécanique, c'est-à-dire un matériau à haute perméabilité et dont la direction de l'axe facile d'aimantation peut être pilotée par une contrainte mécanique.

Toujours selon l'invention, la contrainte mécanique appliquée à l'élément magnétique est une contrainte que l'on peut qualifier indistinctement d'orientée ou de directionnelle, ou d'anisotrope, c'est-à-dire une compression ou une traction dont la composant principale dans tout le matériau est sensiblement alignée selon une direction bien déterminée, la même direction dans tout le matériau.

De plus, ladite contrainte mécanique directionnelle appliquée sur l'élément magnétique résulte de l'application de deux contraintes directionnelles appliquées, de préférence selon deux directions sécantes séparées de sensiblement 45° l'une de l'autre, notamment en fonction du mouvement que l'on souhaite imprimer au mobile aimanté.

Selon une caractéristique avantageuse du procédé de l'invention, on maintient le mobile aimanté dans au moins une position stable en l'absence de contrainte mécanique appliquée sur au moins un élément magnétique, la ou les positions stables étant déterminée par au moins une anisotropie de forme dudit au moins un élément magnétique. De préférence, on maintient le mobile aimanté dans plusieurs positions stables régulièrement espacées les unes des autres en l'absence de contrainte mécanique, lesdites positions stables étant déterminées par une anisotropie périodique identique dudit au moins un élément magnétique. Grâce à cette faculté de maintient de la position du mobile aimanté suivant l'anisotropie du matériau magnétique, on peut notamment envisager et réaliser des applications d'actionnement pas à pas par le procédé de l'invention, en appliquant de façon séquentielle la contrainte mécanique sur le matériau magnétique.

Selon le procédé de l'invention, l'élément magnétique est constitué d'au moins une couche mince ou d'au moins un élément d'un matériau magnétostrictif doux, tels que par exemple les alliages de bases suivantes : FeNi, FeCo, FeAl, FeB, FeSiB, FeCoZrNbB, FeCoSmB, FeCoTbB, obtenus sous forme amorphe ou cristalline..

De préférence encore, l'élément magnétique est solidaire sur un support, notamment un élément piézoélectrique, par exemple de type multifibres composite (MFC) relié à un générateur de tension continue ou alternative. L'utilisation de supports piézoélectriques pour appliquer la contrainte mécanique sur l'élément magnétique s'avère particulièrement avantageuse. En effet, ces matériaux ont la propriété de se déformer relativement peu tout en étant le sein de contraintes mécaniques relativement élevées. De surcroît, les pertes et courants de fuite (en statique) dans ces matériaux sont très faibles, ce qui permet de réduire très fortement la consommation des systèmes actionnés selon le procédé de l'invention. Il convient enfin de noter que la solidarisation du matériau magnétique sur son support doit être telle que la liaison entre les deux éléments soit telle que la contrainte créée par le support soit bien transmise à l'élément magnétique, tant en amplitude qu'en direction. C'est la raison pour laquelle on favorisera une solution de dépôt par pulvérisation, soudage ou collage de l'élément magnétique sur son support.

Un autre aspect de la présente invention concerne par ailleurs un actionneur magnétique configuré pour mettre en oeuvre le procédé de l'invention. Un tel actionneur est caractérisé selon la revendication 9.

Selon un mode de réalisation préféré de l'actionneur de l'invention, les moyens d'application de contrainte comportent au moins un élément piézoélectrique, de préférence de type multifibres composite, sur lequel est apposé le matériau magnétique.

Dans une variante avantageuse de l'actionneur de l'invention, l'élément magnétique présente dans au moins un plan une forme anisotrope, et de préférence encore une anisotropie de forme périodique et identique. Une telle forme anisotrope du matériau magnétique permet de réaliser, par exemple avec un élément magnétique cranté ou en étoile, un actionneur pas à pas permettant le maintien du mobile aimanté dans des positions stables déterminées par l'anisotropie du matériau en l'absence de contraintes mécaniques sur ce matériau, en couplant l'usage de la forme anisotrope avec un pilotage électronique séquentiel des moyens d'application des contraintes mécaniques.

Dans une variante de réalisation, l'élément magnétique de l'actionneur comporte deux couches d'un matériau magnétique et les moyens d'application de contrainte comportent un entrefer électrostatique ménagé par des moyens d'écartement disposé entre les deux couches de matériau magnétique. Dans ce mode de réalisation, des électrodes multiples de part et d'autre de l'entrefer et en forme de quadrants, permettent par exemple d'appliquer une contrainte sensiblement unidirectionnelle et d'orientation angulaire variable en fonction des électrodes activées.

Un tel actionneur magnétique peut avantageusement constituer un interrupteur, un potentiomètre, un moteur ou un indicateur directionnel.

Diverses autres caractéristiques ressortent de la description faite ci-dessous en référence aux dessins annexés qui montrent, à titre d'exemples non limitatifs, des formes de réalisation de l'objet de l'invention.
- la **Fig. 1** représente l'effet d'une contrainte isotrope dans le plan sur une couche mince ou un ruban d'un matériau magnétostrictif sur la direction et l'intensité de l'axe facile d'aimantation de ladite couche ou ruban ;
- la **Fig. 2** représente l'effet d'une contrainte uniaxiale et dans le plan sur une couche mince ou un ruban d'un matériau magnétostrictif et l'apparition d'une direction de facile aimantation dans cette couche en fonction de la direction et du sens de la contrainte appliquée ;
- La **Fig. 3** représente l'effet de rotation dans le plan de l'axe facile d'aimantation d'une couche mince ou d'un ruban non circulaire d'un matériau magnétostrictif sous l'action d'une contrainte uniaxiale ;
- la **Fig. 4** représente l'effet progressif de rotation dans le plan de l'axe facile d'aimantation d'une couche mince ou d'un ruban d'un matériau magnétostrictif sous l'action de deux contraintes uniaxiales indépendantes et séparées d'un angle de 45° ;
- les **Fig. 5A à 5C** représentent différentes variantes préférées de mise en oeuvre d'un élément magnétostrictif et de moyens d'application de contraintes mécaniques sur cet élément pour réaliser un actionneur magnétique conforme à l'invention ;
- la **Fig. 6** représente un premier exemple de réalisation d'un interrupteur à actionnement magnétique fonctionnant selon le procédé de l'invention ;
- la **Fig. 7** représente une variante de réalisation de l'interrupteur de la **Fig. 6** ;
- les **Fig. 8** et **9** représentent d'autres formes de réalisation d'interrupteurs à actionnement magnétique conformes à l'invention ;
- les **Fig. 10 et 11** représentent schématiquement un actionneur rotatif ou moteur à entrainement magnétique fonctionnant selon le procédé de l'invention ;
- les **Fig. 12** à **14** représentent différentes configurations d'actionneurs magnétiques rotatifs conformes à la présente invention.

La présente invention propose un nouveau procédé d'actionnement magnétique qui n'utilise pas de courants électriques pour créer une force magnétique mais propose essentiellement d'utiliser les propriétés de rotation de l'axe facile d'aimantation de certains matériaux sous l'action de contraintes mécaniques pour initier et contrôler un mouvement rotatif ou linéaire d'un mobile formé préférentiellement par un aimant permanent. Le procédé de l'invention peut également être utilisé pour créer un champ magnétique "variable" ou "dirigeable" dans un volume, notamment liquide ou gazeux, dans lequel flottent des cellules ou microparticules magnéto-sensibles.

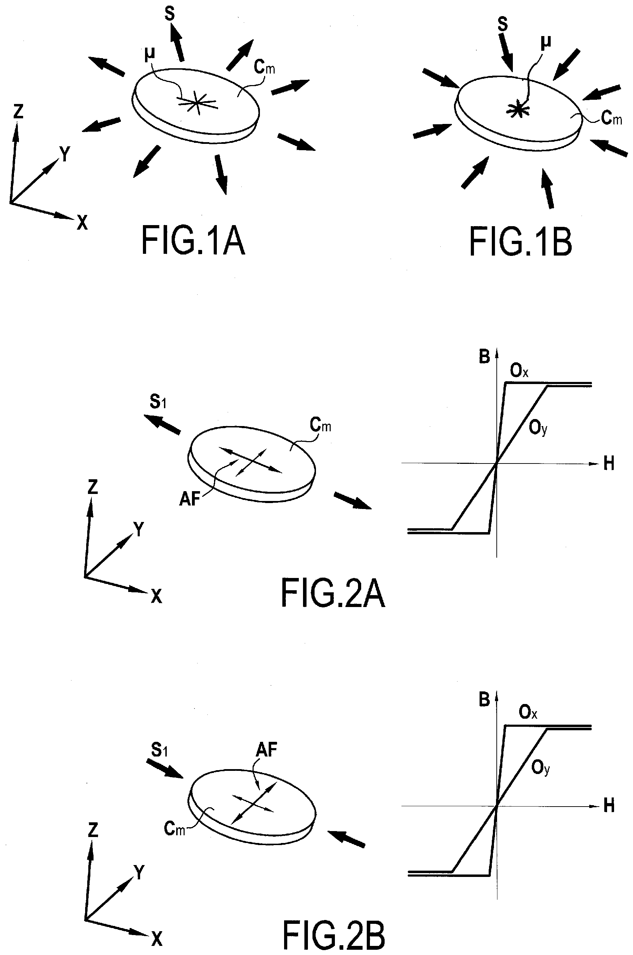

La **Fig. 1** représente l'effet, connu de l'état de la technique, produit par l'application d'une contrainte isotrope **S** sur la perméabilité magnétique **µ** d'une couche **Cm** d'un matériau magnétostrictif à magnétostriction positive tel que, par exemple une couche de Fer-Silicium-Bore (FeSiB). Ainsi, lorsque la contrainte **S** correspond à une traction (1) sur les bords de la couche **Cm,** la perméabilité **µ** du matériau est plus élevée dans le plan de la contrainte que selon l'axe perpendiculaire Oz, sans direction privilégiée dans le plan Oxy sauf en cas de forme géométrique de la couche induisant un effet de forme, ou d'anisotropie cristallographique de celle-ci. A l'inverse, lorsque la contrainte **S** est une compression isotrope (2) la perméabilité magnétique **µ** dans le plan X-Y de ladite couche diminue.

La **Fig. 2** représente la mise en évidence (ou la génération) par l'application d'une contrainte uniaxiale **S₁** en traction (1) et compression (2) respectivement, d'un axe facile d'aimantation **AF** dans une couche **Cm** circulaire d'un matériau magnétostrictif tel que, par exemple du Fer-Silicium-Bore (FeSiB).

Ainsi, on peut remarquer que l'orientation de l'axe facile **AF** dépend de la contrainte. Dans le cas d'un matériau à magnétostriction positive, lorsque la contrainte appliquée est une traction (1), axe facile **AF** est orienté parallèlement à l'axe de la contrainte. Par opposition, lorsque la contrainte appliquée à la couche **Cm** est une compression (2), l'axe facile **AF** est orienté orthogonalement à l'axe de ladite contrainte. Les effets en traction et compression s'inversent dans le cas d'un matériau à magnétostriction négative.

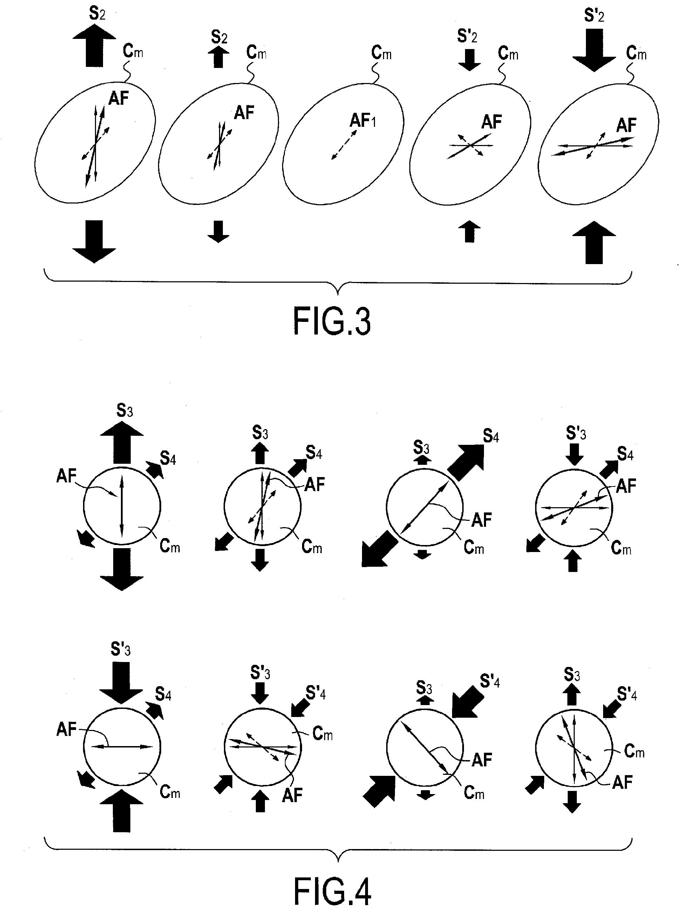

La **Fig. 3** représente la faculté de rotation de l'axe facile d'aimantation **AF** d'une couche mince **Cm** de matériau magnétostrictif de forme géométrique anisotrope déterminée, en l'espèce ovale ou elliptique, en fonction d'une variation d'intensité et de sens d'une contrainte **S₂** appliquée dans une direction intermédiaire aux axes principaux de la couche **Cm.** Le facteur de forme de la géométrie non circulaire de la couche induit une direction privilégiée d'aimantation, dans le cas présent le long du grand axe.

On peut ici constater, en observant la séquence représentée de gauche à droite sur la **Fig. 3****,** que l'intensité et le sens de la contrainte **S₂** appliquée sur la couche mince **Cm** dans une seule direction modifient la direction privilégiée d'aimantation **AF** de ladite couche **Cm.**

Ainsi, lorsque l'on applique une contrainte de traction **S₂** croissante dans une direction sensiblement décalée d'un certain angle par rapport à l'axe facile de la couche **Cm,** la direction de l'axe facile **AF** tend à se rapprocher progressivement de la parallèle à la direction de la contrainte, et quand au contraire on applique une contrainte de compression **S'₂** croissante, toujours selon cette même direction décalée, l'axe facile **AF** s'oriente progressivement selon une droite sensiblement perpendiculaire à la direction d'application de la contrainte **S'₂.**

On peut donc en jouant sur le signe et l'intensité d'une seule contrainte unidirectionnelle appliquée à une couche **Cm** présentant une anisotropie de forme orienter continument la direction d'aimantation privilégiée **AF** dans le plan de la couche mince **Cm.** L'utilisation de formes anisotropes du matériau magnétique permet de façon avantageuse la réalisation d'actionneurs pas à pas.

La **Fig. 4** représente l'effet de rotation continue de la direction d'aimantation privilégiée **AF** d'une couche mince **Cm** de matériau magnétique (ici la couche mince est de géométrie circulaire, et donc isotrope, et ne présente donc pas naturellement d'axe facile d'aimantation, contrairement à l'ellipse de la figure 3 ci-dessus.). L'effet de rotation continue est produit par l'action conjuguée de deux contraintes indépendantes **S₃, S₄** de traction ou **S'₃, S'₄** de compression, dont les axes d'application sont décalés d'un angle de 45° dans le plan de la couche **Cm.**

Comme cela ressort de cette **Fig. 4****,** observée de la gauche vers la droite et de haut en bas, l'axe facile **AF** peut être orienté dans n'importe quelle direction angulaire dans le plan d'une couche **Cm,** en jouant sur le signe (compression ou traction) et l'intensité des deux contraintes unidirectionnelles **S₃, S₄** et/ou **S'₃, S'₄** appliquées sur ladite couche **Cm.**

Il convient en outre de noter que dans l'expérience réalisée par les inventeurs, les deux contraintes appliquées sur la couche mince **Cm** sont sinusoïdales dans le temps avec un déphasage temporel de 90°, ce qui permet de piloter l'axe facile en rotation sensiblement uniforme.

Le procédé d'actionnement de la présente invention repose sur le fait que dans certains matériaux magnétiques, comme notamment le FeSiB, une anisotropie ou une direction d'axe facile d'aimantation **AF** peuvent être créées et contrôlée sous l'action de contraintes mécaniques. Le procédé de l'invention n'exploite pas, contrairement à l'état de la technique la variation d'intensité de la perméabilité du matériau, qu'elle soit globale ou locale selon que la contrainte est appliquée sur tout le matériau ou localement seulement.

En effet, l'interaction entre un aimant permanent et un matériau magnétique doux dépend notamment de l'axe facile d'aimantation **AF** du matériau doux et de la polarisation de l'aimant permanent. Lorsque l'axe facile **AF** du matériau magnétique varie, il est possible de créer un déséquilibre de force et/ou couple sur l'aimant permanent obligeant l'aimant à se déplacer, et notamment à tourner le cas échéant.

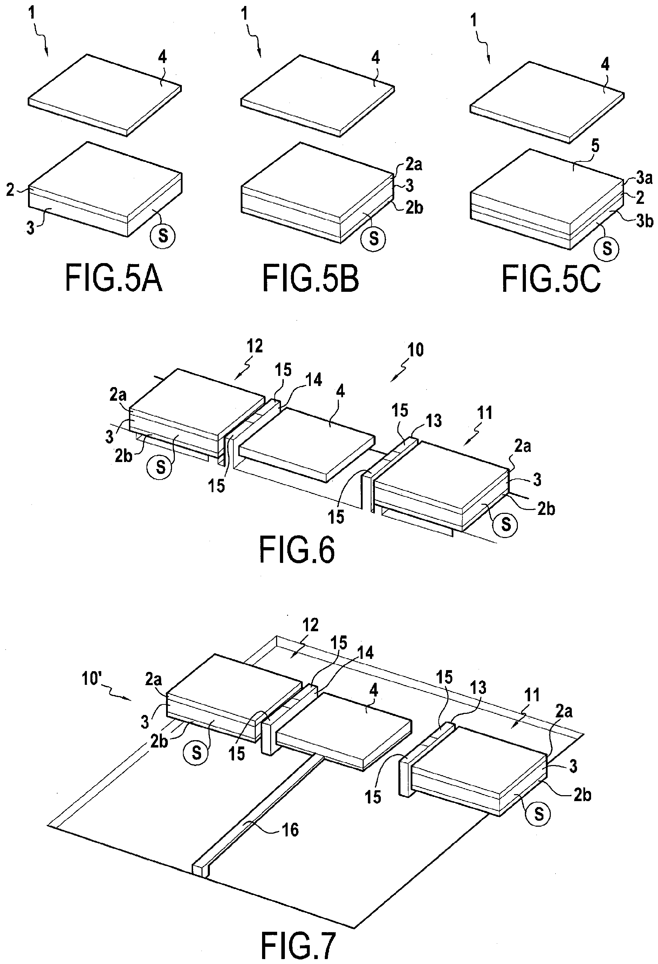

On réalise ainsi un actionnement magnétique qu'il est possible d'exploiter conformément à la présente invention dont différents exemples de mise en oeuvre pratique vont être décrits ci-après en référence aux **Fig. 5A** à **14****.**

Les **Fig. 5A** à **5C** représentent en premier lieu différentes configurations préférées de montage d'un élément magnétique soumis à des contraintes pour permettre le déplacement d'un mobile aimanté et réaliser un actionneur magnétique apte à mettre en oeuvre le procédé de l'invention.

La **Fig. 5A** représente la configuration la plus simple de réalisation d'un actionneur magnétique **1** conforme à l'invention. Une couche mince **2** de fer-silicium-bore amorphe FeSiB est collée sur une plaque formée d'un piézoélectrique **3** de type multifibre composite "MFC". Un mobile aimanté **4** de néodyme-fer-bore (NdFeB) ou samarium-cobalt (SmCo) ou fer-platine ou ferrite par exemple, est placé en proche proximité. Tous ces matériaux d'aimants permanents sont des matériaux courants du commerce ou connus de l'état de l'art.

La plaque piézoélectrique **3** est connectée à un générateur **5** de tension continue ou alternative. En appliquant une tension à ladite plaque **3,** celle-ci exerce alors une contrainte mécanique uniaxiale sur la couche mince magnétique **2,** dont résulte une orientation de la direction privilégiée ou axe facile d'aimantation **AF** de la couche **2** conformément aux principes énoncés précédemment en référence aux **Fig. 1** à **4****.**

Ainsi, le flux magnétique d'un mobile aimanté **4** placé à côté ou en suspension au dessus de l'assemblage formé de la couche mince **2** et du piézoélectrique **3** a donc tendance à être canalisé au sein de la couche **2** selon la direction privilégié correspondant à l'orientation de l'axe facile **AF** dans ladite couche, ce qui se traduit par une force ou un couple dont résulte à son tour le déplacement en rotation ou translation de l'aimant **4** par rapport à l'assemblage de la couche magnétique **2** et de la plaque piézoélectrique **3.**

Dans un cas plus particulier, une contrainte anisotrope peut être appliquée sur la couche **2** de FeSiB lorsque la plaque piézoélectrique **3** utilisée est une plaque de type MFC qui travaille dans une seule direction. Dans ce cas, l'application d'une tension sur la plaque **3** au moyen d'un générateur de tension **5** entraîne au sein de la couche **2** une rotation de la direction d'aimantation privilégiée dans son plan. L'aimant permanent **4** placé au dessus de ladite couche **2** subit alors à un couple pour aligner son flux dans cette nouvelle direction, et cela se traduit par un mouvement de rotation de l'aimant **5** qui peut alors être exploité.

Dans une première variante de réalisation préférée représentée à la **Fig. 5B****,** l'actionneur magnétique **1** peut comporter deux couches magnétiques de FeSiB **2a, 2b** déposées de part et d'autre d'une plaque d'un piézoélectrique **3** prise en sandwich entre les deux dites couches **2a, 2b.** Cette configuration en sandwich permet d'éviter les phénomènes de flexion de type bilame ou bimorphe qui peuvent être rencontrés lorsque l'on a une dissymétrie des couches **2, 3** comme représenté à la **Fig. 5A****.** Il est à noter que les deux couches magnétiques **2a, 2b,** peuvent servir comme électrodes pour la plaque piézoélectrique **3** si elles sont conductrices.

Dans une deuxième variante de réalisation préférée représentée à la **Fig. 5C****,** l'actionneur magnétique **1** peut comporter deux plaques piézoélectriques **3a, 3b** apposées de part et d'autre d'un couche magnétique **2** prise en sandwich entre les deux dites plaques **3a, 3b.** Cette configuration permet d'appliquer deux contraintes indépendantes l'une de l'autre en valeur et direction sur une même couche magnétique **2,** par exemple pour entraîner le mobile aimanté **4** en rotation complète à 360° sur lui-même.

Les **Fig. 6** à **9** représentent différentes variantes de réalisation d'un actionneur magnétique linéaire conforme à l'invention et constituant un interrupteur **10, 10', 20, 20'.** Dans la description qui va suivre, les éléments communs à ceux des actionneurs des **Fig. 5A** à **5C** portent les mêmes références numériques.

Ces différentes variantes de réalisation mettent en oeuvre le principe de changement de direction et d'intensité de l'axe facile d'aimantation d'une couche magnétique décrit aux **Fig. 1, 2****,** ou **3****.**

Tel que représenté sur la **Fig. 6****,** l'interrupteur **10** comprend en particulier un mobile aimanté **4** formé par un aimant permanent et flottant en translation entre deux assemblages **11, 12** constitués chacun de deux couches magnétiques de FeSiB **2a, 2b** déposées sur une plaque **3** d'un matériau piézoélectrique connecté à un générateur de tension **5.** Intercalées entre un côté de chaque assemblage **11, 12** et le mobile aimanté **4** se trouvent deux parois **13, 14** destinées à limiter l'étendue des mouvements du mobile aimanté **4,** de sorte que les couches **2a, 2b** des assemblages **11, 12** ne saturent pas ni qu'au contraire le mobile **4** ne soit hors de portée magnétique desdits assemblages. Les parois **13, 14** sont en outre recouvertes chacune sur leur rebord supérieur d'une couche métallique **15** adaptée pour établir un contact électrique avec le mobile aimanté **4** lors des déplacements de celui-ci sous l'attraction combinées des assemblages **11, 12** lorsque ces derniers sont mis sous tension des générateurs **5** séparément et de manière complémentaire.

La **Fig. 7** représente un interrupteur **10'** similaire à celui de la **Fig. 6** mais dans lequel le mobile aimanté **4** est porté sur un bras ressort **16.** Ce bras **16** ajoute une force supplémentaire de soutien du mobile aimanté **4,** qui en combinaison avec les forces d'attraction magnétique exercées sur le mobile **4** par les assemblages **11, 12** permet de régler la force de déplacement du mobile **4** et de contraindre ce déplacement en mouvement de translation linéaire entre les parois **13,14** de l'interrupteur **10'.**

Dans ce mode de réalisation, les assemblages **11, 12** quant à eux peuvent présenter une structure identique à celles proposées sur la **Fig. 6****.** Ils sont pilotés séparément et de manière complémentaire.

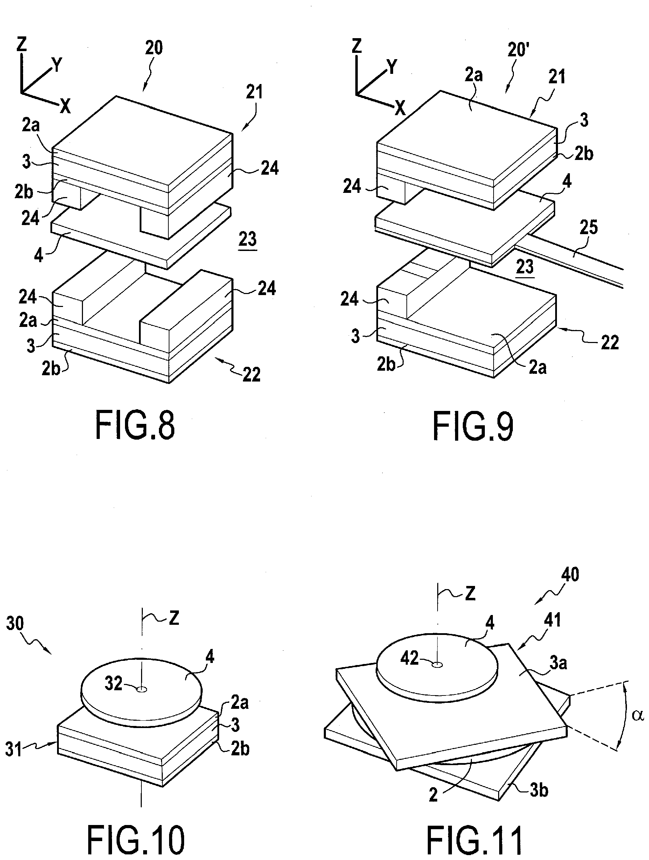

Les **Fig. 8** et **9** représentent deux autres variantes de réalisation d'un interrupteur **20, 20'** respectivement, fonctionnant selon le procédé d'actionnement magnétique de la présente invention. Dans ces deux variantes, l'interrupteur **20, 20'** comporte deux assemblages actionneurs **21, 22** constitués chacun de deux couches **2a, 2b** de matériau magnétostrictif entre lesquelles est intercalée une plaque d'un matériau piézoélectrique **3.** Les deux assemblages **21, 22** présentent ainsi une structure similaire à celle des assemblages **11, 12** des interrupteurs **10, 10'** des **Fig. 5** et **6****,** et sont eux aussi pilotés séparément et de manière complémentaire. Les deux assemblages **21,22** sont disposés l'un au dessus de l'autre et un mobile aimanté **4,** formé par un aimant permanent est disposé mobile en translation verticale dans un espace **23** de déplacement du mobile **4** ménagé entre les assemblages **21, 22.** De façon analogue aux parois **13, 14** décrites précédemment pour les variantes des **Fig. 6** et **7****,** des cales **24** de contact, revêtues avantageusement d'une couche métallique conductrice, sont disposées entre les assemblages **21, 22** et le mobile **4.**

De plus, les assemblages **21, 22** sont chacun connectés à un générateur de tension alternative ou continue, non représenté sur les figures, permettant de solliciter le piézoélectrique **3** et ainsi d'appliquer une contrainte mécanique sur les couches magnétiques **2a, 2b** pour provoquer le déplacement du mobile **4** dans l'espace **23.**

Dans la variante de la **Fig. 9****,** le mobile aimanté **4** est porté par un bras ressort **25** alors que dans la variante de la **Fig. 8** ledit mobile **4** est maintenu en position purement par la force magnétique.

Dans la variante de la **Fig. 9****,** le bras **25** sert à maîtriser le mobile **4** suivant un mouvement de translation linéaire et également à ajouter une force de soutien non-magnétique et indépendante de la force magnétique exercée entre mobile **4** et assemblages actionneurs **21, 22** pour régler le déplacement du mobile **4.**

La variante de la **Fig. 8** présente l'avantage d'être d'une construction plus simple, sans bras de soutien et guidage du mobile **4,** la force de contact étant simplement plus forte entre le mobile **4** et les cales **24** de contact.

Les **Fig. 10** à **14** représentent d'autres variantes d'actionneurs magnétiques conformes à la présente invention dans lesquelles l'actionnement d'un mobile aimanté est effectué en rotation, conformément aux principes précédemment explicités en référence aux **Fig. 3** et **4****.**

Ces actionneurs magnétiques sont basés sur la rotation de l'axe facile d'aimantation **AF** décrite sur les **Fig. 3** et **4****.**

La **Fig. 10** représente un actionneur magnétique rotatif **30** dont la course est limitée dans une plage angulaire de 90°. Cet actionneur **30** comporte un assemblage d'actionnement **31** composé de deux couches magnétiques **2a, 2b** apposées sur chaque coté d'une plaque **3** formée d'un piézoélectrique alimenté par un générateur de tension continue ou alternative, non représenté.

Un mobile aimanté **4,** aimanté dans le plan de l'assemblage **31,** est placé au dessus de ce dernier et confiné en mouvement rotatif par un tourillon **32.** Le mobile aimanté **4** induit une aimantation dans les couches magnétiques **2a, 2b.** L'axe facile des couches **2a, 2b** est contrôlé par la nature et l'intensité de la contrainte mécanique appliquée par le piézoélectrique **3.** Lorsque la direction de l'aimantation induite par le mobile **4** n'est pas parallèle à la direction de l'axe facile des couches **2a, 2b,** ces deux directions ont tendance à s'aligner : il existe alors un couple entre le mobile aimanté **4** et l'assemblage d'actionnement **31.** Il est ainsi possible d'exploiter la mobilité rotationnelle du mobile aimanté dans le but de réaliser des fonctions d'actionnement en rotation.

La **Fig. 11** représente une variante de l'actionneur magnétique de la **Fig. 10****.** Cette variante présente un actionneur rotatif **40,** comportant un mobile aimanté **4** apte à suivre une rotation de 360°, conformément aux principes de rotation de l'axe facile d'aimantation d'un matériau magnétique décrits précédemment en relation avec la **Fig. 4****.**

Cet actionneur comporte un assemblage d'actionnement **41** comportant deux éléments piézoélectriques **3a, 3b,** distincts et décalés d'un angle α de 45° l'un par rapport à l'autre autour d'un axe vertical **Z** perpendiculaire à chacun des éléments piézoélectriques, qui imposent des contraintes sur une couche magnétique **2** disposée entre les deux éléments **3a, 3b.** Le mobile **4,** aimanté selon une direction parallèle au plan supérieur de l'assemblage **41** est placé au dessus et confiné en mouvement rotatif par un tourillon **42.**

Pour pouvoir contraindre simultanément selon deux directions distinctes la couche de matériau magnétique **2** et entraîner le mobile **4** en rotation, les deux éléments piézoélectriques **3a, 3b** sont reliés indépendamment à des générateurs de tension continue ou alternative. L'alimentation en tension des deux éléments piézoélectriques engendre la création de deux contraintes distinctes qui sont conjuguées sur la couche magnétique **2,** et en faisant varier la tension d'alimentation on provoque une variation relative des contraintes ce qui engendre une rotation de l'axe facile d'aimantation de la couche **2,** qui à son tour provoque l'entraînement en rotation du mobile aimanté **4.**

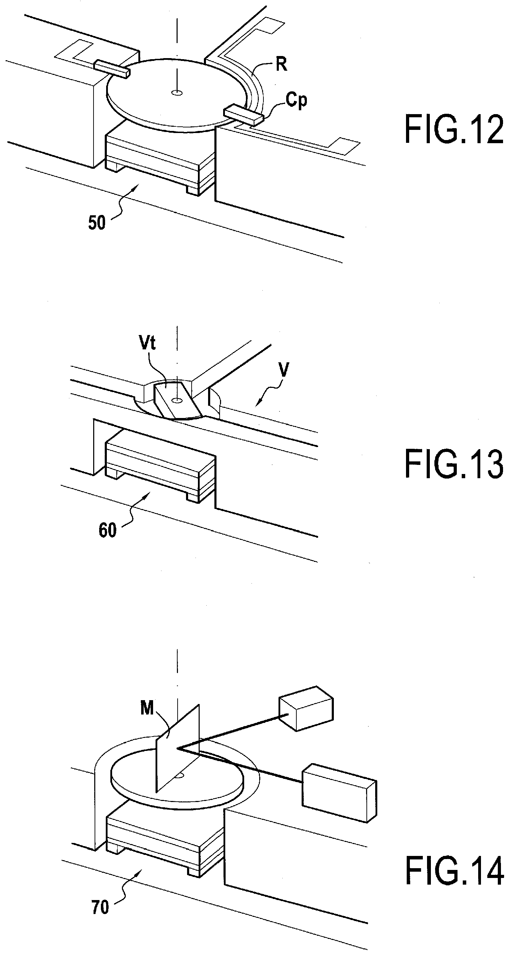

Les **Fig. 12** à **14** représentent schématiquement l'utilisation d'actionneurs tels que décrits et représentés aux **Fig. 10** et **11** dans des applications avec des composants susceptibles à réchauffement et pour lesquels le positionnement dans un état statique est plus intéressant que le mouvement dynamique.

La **Fig. 12** représente schématiquement un actionneur magnétique angulaire **50** pour le contrôle de la position d'un potentiomètre. Cet actionneur présente une structure identique à celui de la **Fig. 10****.** Un curseur de positionnement **Cp** est fixé sur le mobile aimanté et s'étend au dessus d'une résistance **R** de façon à balayer celle-ci lors des mouvements du mobile **4** et ainsi faire varier ladite résistance **R.**

La **Fig. 13** représente schématiquement un actionneur magnétique angulaire **60** pour le contrôle de la position d'une valve **V** fluidique ou bio-fluidique où les propriétés des fluides (souvent organique) et /ou l'aspect biologique (les cellules par exemple) sont susceptible à la chaleur. Dans cet exemple, le mobile aimanté de l'actionneur, dont la structure est une fois encore identique à celle des **Fig. 10 ou 11****,** supporte ou forme le volet **Vt** de fermeture des différentes voies de la valve.

La **Fig. 14** représente enfin schématiquement un actionneur magnétique angulaire **70** pour le contrôle de la position d'un miroir, réseau de diffraction ou photodétecteur **M.** Dans cet exemple, l'actionneur présente une fois encore une structure similaire à celle des actionneurs décrits aux **Fig. 10 ou 11****.**

Ce genre d'actionneur **70** peut être utilisé comme interrupteur optique pour la communication par fibres optiques, ou moyen de choisir une fréquence de lumière parmi d'autres pour les filtres optiques, pour la communication par fibre optique ou pour l'analyse spectroscopique.

La qualité optique est dépendante de la planéité du miroir **M** qui peut changer avec la chaleur. De plus l'émission de la lumière infrarouge par les éléments chauds exclue souvent l'utilisation d'actionneurs utilisant les bobinages dans des applications optique dans le domaine l'infrarouge.

Dans les différentes variantes d'actionneurs magnétiques présentées, on peut également envisager d'appliquer la contrainte mécanique sur la ou les couches magnétiques de l'actionneur par déformation électrostatique, thermique, effort mécanique direct ou toute autre méthode.

L'invention n'est pas limitée aux exemples décrits et représentés car diverses modifications peuvent y être apportées sans sortir de son cadre, défini par les revendications.

## Revendications

1. Procédé d'actionnement magnétique, selon lequel on dirige un mobile aimanté **(4)** au moyen d'au moins un élément magnétique **(2, 2a, 2b)** disposé en regard dudit mobile aimanté, dans lequel on fait tourner la direction privilégiée (ou axe facile) d'aimantation en tout point dudit élément par application d'au moins une contrainte mécanique sur le(s) dit(s) élément(s) magnétique(s) **(2, 2, 2b),** provoquant une anisotropie au sein dudit élément et entraînant ainsi le mobile aimanté suivant une rotation ou une direction linéaire privilégiée, **caractérisé en ce que** la contrainte mécanique appliquée est une contrainte unidirectionnelle qui résulte de la combinaison bidirectionnelle de deux contraintes unidirectionnelles appliquées de préférence selon deux directions sécantes séparées de sensiblement 45° l'une de l'autre, et **en ce que** l'élément magnétique est constitué d'au moins une couche mince **(Cm)** ou d'au moins un élément d'un matériau magnétostrictif doux, tels que les alliages de bases suivantes : FeNi, FeCo, FeAl, FeB, FeSiB, FeCoZrNbB, FeCoSmB, FeCoTbB, obtenus sous forme amorphe ou cristalline.

2. Procédé selon la revendication 1, **caractérisé en ce que** l'élément magnétique **(2, 2a, 2b)** est constitué d'un matériau magnétique choisi parmi les matériaux magnétostrictifs doux dont l'axe facile d'aimantation peut tourner sous l'effet d'une contrainte mécanique.

3. Procédé selon la revendication 1 ou 2, **caractérisé en ce que** la contrainte mécanique appliquée est une contrainte orientée ou directionnelle ou anisotrope.

4. Procédé selon l'une des revendications 1 à 3, **caractérisé en ce que** la contrainte mécanique appliquée sur l'élément magnétique est une contrainte unidirectionnelle.

5. Procédé selon l'une des revendications 1 à 4, **caractérisé en ce que** l'on maintient le mobile aimanté dans au moins une position stable en l'absence de contrainte mécanique appliquée sur au moins un élément magnétique, la ou les positions stables étant déterminée par au moins une anisotropie de forme dudit au moins un élément magnétique.

6. Procédé selon la revendication 5, **caractérisé en ce que** l'on maintient le mobile aimanté dans plusieurs positions stables régulièrement espacées les unes des autres en l'absence de contrainte mécanique, lesdites positions stables étant déterminées par une anisotropie périodique identique dudit au moins un élément magnétique.

7. Procédé selon l'une quelconque des revendications précédentes, **caractérisé en ce que** l'élément magnétique est déposé sur un support **(3, 3a, 3b),** de préférence piézoélectrique, relié à un générateur de tension **(5)** continue ou alternative.

8. Procédé selon la revendication 7, **caractérisé en ce que** le support est un élément piézoélectrique **(3)** de type multifibres composite.

9. Actionneur magnétique **(1, 10, 10', 20, 20', 30, 40, 50, 60, 70),** comportant au moins un mobile aimanté **(4)** monté mobile relativement à un élément magnétique **(2)** dont l'axe facile d'aimantation est variable sous l'action d'une contrainte mécanique, et comportant en outre des moyens **(3, 3a, 3b, 5)** d'application d'au moins une contrainte mécanique sur l'élément magnétique, **caractérisé en ce que** la contrainte mécanique appliquée est une contrainte unidirectionnelle qui résulte de la combinaison bidirectionnelle de deux contraintes unidirectionnelles appliquées de préférence selon deux directions sécantes séparées de sensiblement 45° l'une de l'autre, et **en ce que** l'élément magnétique est constitué d'au moins une couche mince **(Cm)** ou d'au moins un élément d'un matériau magnétostrictif doux, tels que les alliages de bases suivantes : FeNi, FeCo, FeAl, FeB, FeSiB, FeCoZrNbB, FeCoSmB, FeCoTbB, obtenus sous forme amorphe ou cristalline.

10. Actionneur magnétique selon la revendication 9, **caractérisé en ce que** les moyens d'application de contrainte comportent au moins un élément piézoélectrique **(3, 3a, 3b)** sur lequel est plaqué le matériau magnétique **(2)** afin que la contrainte générée par l'élément piézoélectrique soit transmise au matériau magnétique.

11. Actionneur magnétique selon la revendication 9, **caractérisé en ce que** l'élément magnétique **(2)** comporte deux couches **(2a, 2b)** d'un matériau magnétique et **en ce que** les moyens d'application de contrainte comportent un entrefer électrostatique ménagé par des moyens d'écartement disposé entre les deux couches de matériau magnétique.

12. Actionneur magnétique selon la revendication 11, **caractérisé en ce que** les moyens d'application de contrainte comportent des électrodes multiples de part et d'autre de l'entrefer et en forme de quadrants.

13. Actionneur magnétique selon l'une des revendications 9 à 12, **caractérisé en ce que** l'élément piézoélectrique **(3, 3a, 3b)** est de type multifibres composite.

14. Actionneur magnétique selon l'une des revendications 9 à 13, **caractérisé en ce que** l'élément magnétique présente dans au moins un plan une forme anisotrope.

15. Actionneur selon la revendication 14, **caractérisé en ce que** l'élément magnétique présente dans au moins un plan une anisotropie de forme périodique identique.

16. Utilisation d'un actionneur magnétique selon l'une des revendications 9 à 15 en tant que commutateur, interrupteur, moteur ou indicateur directionnel.

## Patentansprüche

1. Verfahren für magnetischen Antrieb, demgemäß eine magnetisierte bewegliche Einheit (4) mittels mindestens eines der magnetisierten beweglichen Einheit gegenüberliegenden magnetischen Elements (2, 2a, 2b) gelenkt wird, wobei die Vorzugsrichtung (oder einfache Achse) der Magnetisierung an jedem beliebigen Punkt des Elements gedreht wird, indem mindestens eine mechanische Spannung auf das/die magnetische(n) Element(e) (2, 2, 2b) ausgeübt wird, was eine Anisotropie innerhalb des Elements verursacht und somit die magnetisierte bewegliche Einheit entlang einer Rotation oder einer linearen Vorzugsrichtung antreibt, **dadurch gekennzeichnet, dass** die ausgeübte mechanische Spannung eine unidirektionale Spannung ist, die sich aus der bidirektionalen Kombination von zwei unidirektionalen Spannungen ergibt, die vorzugsweise in zwei sich schneidenden Richtungen im Wesentlichen 45° voneinander entfernt ausgeübt werden, und dass das magnetische Element aus mindestens einer dünnen Schicht (Cm) oder mindestens einem Element aus einem weichen magnetostriktiven Material besteht, wie den folgenden Basislegierungen: FeNi, FeCo, FeAl, FeB, FeSiB, FeCoZrNbB, FeCoSmB, FeCoTbB, erhalten in amorpher oder kristalliner Form.

2. Verfahren gemäß Anspruch 1, **dadurch gekennzeichnet, dass** das magnetische Element (2, 2a, 2b) aus einem magnetischen Material besteht, das aus weichem magnetostriktiven Materialien ausgewählt ist, deren leichte Magnetisierungsachse sich unter dem Einfluss einer mechanischen Spannung drehen kann.

3. Verfahren gemäß Anspruch 1 oder 2, **dadurch gekennzeichnet, dass** die ausgeübte mechanische Spannung eine orientierte oder gerichtete oder anisotrope Spannung ist.

4. Verfahren gemäß einem der Ansprüche 1 bis 3, **dadurch gekennzeichnet, dass** die auf das magnetische Element ausgeübte mechanische Spannung eine unidirektionale Spannung ist.

5. Verfahren gemäß einem der Ansprüche 1 bis 4, **dadurch gekennzeichnet, dass** die magnetisierte bewegliche Einheit in mindestens einer stabilen Position gehalten wird, wenn keine mechanische Spannung auf mindestens ein magnetisches Element ausgeübt wird, wobei die stabile Position(en) durch mindestens eine Form-Anisotropie des mindestens einen magnetischen Elements bestimmt wird (werden).

6. Verfahren gemäß Anspruch 5, **dadurch gekennzeichnet, dass** die magnetisierte bewegliche Einheit in mehreren regelmäßig voneinander beabstandeten stabilen Positionen gehalten wird, wenn keine mechanische Spannung vorliegt, wobei die stabilen Positionen durch eine identische periodische Anisotropie des mindestens einen magnetischen Elements bestimmt werden.

7. Verfahren gemäß einem der vorangehenden Ansprüche, **dadurch gekennzeichnet, dass** das magnetische Element auf einem vorzugsweise piezoelektrischen Träger (3, 3a, 3b), aufgebracht ist, der mit einem Gleich- oder Wechselspannungsgenerator (5) verbunden ist.

8. Verfahren gemäß Anspruch 7, **dadurch gekennzeichnet, dass** der Träger ein piezoelektrisches Element (3) vom Typ Multiverbundfaser ist.

9. Magnetischer Stellantrieb (1, 10, 10', 20, 20', 30, 40, 50, 60, 70), umfassend mindestens eine magnetisierte bewegliche Einheit (4), die relativ zu einem magnetischen Element (2) beweglich gelagert ist, dessen einfache Magnetisierungsachse unter der Einwirkung einer mechanischen Spannung veränderbar ist, und ferner Mittel (3, 3a, 3b, 5) zum Ausüben mindestens einer mechanischen Spannung auf das magnetische Element umfasst, **dadurch gekennzeichnet, dass** die ausgeübte mechanische Spannung eine unidirektionale Spannung ist, die sich aus der bidirektionalen Kombination von zwei unidirektionalen Spannungen ergibt, die vorzugsweise in zwei sich schneidenden Richtungen im Wesentlichen 45° voneinander entfernt ausgeübt werden, und dass das magnetische Element aus mindestens einer dünnen Schicht (Cm) oder mindestens einem Element aus einem weichen magnetostriktiven Material besteht, wie den folgenden Basislegierungen: FeNi, FeCo, FeAl, FeB, FeSiB, FeCoZrNbB, FeCoSmB, FeCoTbB, erhalten in amorpher oder kristalliner Form.

10. Magnetischer Stellantrieb gemäß Anspruch 9, **dadurch gekennzeichnet, dass** die Mittel zum Ausüben einer Spannung mindestens ein piezoelektrisches Element (3, 3a, 3b) umfassen, auf dem das magnetische Material (2) so beschichtet ist, dass die von dem piezoelektrischen Element erzeugte Spannung auf das magnetische Material übertragen wird.

11. Magnetischer Stellantrieb gemäß Anspruch 9, **dadurch gekennzeichnet, dass** das magnetische Element (2) zwei Schichten (2a, 2b) aus einem magnetischen Material aufweist und dass die Mittel zum Ausüben einer Spannung einen elektrostatischen Luftspalt aufweisen, der durch zwischen den beiden Schichten aus magnetischem Material angeordnete Abstandshaltermittel ausgebildet wird.

12. Magnetischer Stellantrieb gemäß Anspruch 11, **dadurch gekennzeichnet, dass** die Mittel zum Ausüben einer Spannung mehrere Elektroden auf beiden Seiten des Luftspalts und in Form von Quadranten aufweisen.

13. Magnetischer Stellantrieb gemäß einem der Ansprüche 9 bis 12, **dadurch gekennzeichnet, dass** das piezoelektrische Element (3, 3a, 3b) vom Typ Multiverbundfaser ist.

14. Magnetischer Stellantrieb gemäß einem der Ansprüche 9 bis 13, **dadurch gekennzeichnet, dass** das magnetische Element in mindestens einer Ebene eine anisotrope Form aufweist.

15. Stellantrieb gemäß Anspruch 14, **dadurch gekennzeichnet, dass** das magnetische Element in mindestens einer Ebene eine Anisotropie gleicher periodischer Form aufweist.

16. Verwendung eines magnetischen Stellantriebs gemäß einem der Ansprüche 9 bis 15 als Umschalter, Leistungsschalter, Motor oder Fahrtrichtungsanzeiger.

## Claims

1. Magnetic actuating method whereby a magnetized moving body (4) is directed by means of at least one magnetic element (2, 2a, 2b) arranged facing said magnetized moving body, wherein the priority direction (or easy axis) of magnetization is rotated at every point of said element by applying at least one mechanical stress to said magnetic element(s) (2, 2, 2b), causing anisotropy within said element and thereby driving the magnetized moving body in a priority rotation or linear direction, **characterized in that** the applied mechanical stress is unidirectional stress resulting from the bidirectional combination of two unidirectional stresses preferably applied along two secant directions separated by substantially 45° from one another, and **in that** the magnetic element is composed of at least one thin layer (Cm) or of at least one element of a soft magnetostrictive material such as the alloys based on the following: FeNi, FeCo, FeAl, FeB, FeSiB, FeCoZrNbB, FeCoSmB, FeCoTbB, obtained in amorphous or crystalline form.

2. The method according to claim 1, **characterized in that** the magnetic element (2, 2a, 2b) is composed of a magnetic material selected from among soft magnetostrictive materials having an axis of easy magnetization that is able to rotate under the effect of mechanical stress.

3. The method according to claim 1 or 2, **characterized in that** the applied mechanical stress is oriented or directional or anisotropic stress.

4. The method according to one of claims 1 to 3, **characterized in that** the mechanical stress applied to the magnetic element is unidirectional stress.

5. The method according to one of claims 1 to 4, **characterized in that** the magnetized moving body is held in at least one stable position in the absence of mechanical stress applied to at least one magnetic element, the stable position(s) being determined by at least one shape anisotropy of said at least one magnetic element.

6. The method according to claim 5, **characterized in that** the magnetized moving body is held in several stable positions regularly spaced apart from each other in the absence of mechanical stress, said stable positions being determined by identical periodic anisotropy of said at least one magnetic element.

7. The method according to any of the preceding claims, **characterized in that** the magnetic element is placed on a support (3, 3a, 3b), preferably piezoelectric, connected to a direct or alternating voltage generator (5).

8. The method according to claim 7, **characterized in that** the support is a piezoelectric element (3) of composite multifibre type.

9. Magnetic actuator (1, 10, 10', 20, 20', 30, 40, 50, 60, 70), comprising at least one magnetized moving body (4) mounted mobile relative to a magnetic element (2) having an axis of easy magnetization that is variable under the action of mechanical stress, and further comprising means (3, 3a, 3b, 5) to apply at least one mechanical stress onto the magnetic element, **characterized in that** the applied mechanical stress is unidirectional stress resulting from the bidirectional combination of two unidirectional stresses preferably applied along two secant directions separated substantially by 45° from one another, and **in that** the magnetic element is composed of at least one thin layer (Cm) or of at least one element of a soft magnetostrictive material, such as the alloys based on the following: FeNi, FeCo, FeAl, FeB, FeSiB, FeCoZrNbB, FeCoSmB, FeCoTbB, obtained in amorphous or crystalline form.

10. The magnetic actuator according to claim 9, **characterized in that** the stress-applying means comprise at least one piezoelectric element (3, 3a, 3b) against which the magnetic material (2) is pressed so that the stress generated by the piezoelectric element is transmitted to the magnetic material.

11. The magnetic actuator according to claim 9, **characterized in that** the magnetic element (2) comprises two layers (2a, 2b) of a magnetic material and **in that** the stress-applying means comprise an electrostatic air gap afforded by spacer means arranged between the two layers of magnetic material.

12. The magnetic actuator according to claim 11, **characterized in that** the stress-applying means comprise multiple electrodes either side of the air gap and in the form of quadrants.

13. The magnetic actuator according to one of claims 9 to 12, **characterized in that** the piezoelectric element (3, 3a, 3b) is of composite multifibre type.

14. The magnetic actuator according to one of claims 9 to 13, **characterized in that** the magnetic element displays anisotropic shape in at least one plane.

15. The actuator according to claim 14, **characterized in that** the magnetic element displays identical periodic shape anisotropy in at least one plane.

16. Use of a magnetic actuator according to one of claims 9 to 15 as selector switch, switch, motor or direction indicator.
